# EUROPEAN PATENT SPECIFICATION

(11) **EP 0 927 911 B1**
(45) Date of publication and mention of the grant of the patent: **02.03.2005**
(21) Application number: 98309563.9
(22) Date of filing: 23.11.1998
(51) Int. Cl.: G03F 7/029, G03F 7/033, G03F 7/027

(54) **Photoimageable compositions containing photopolymerizable urethane oligomers**
Urethanoligomere enthaltende lichtempfindliche Zusammensetzungen
Compositions photosensibles contenant des oligomères d'uréthane

(30) Priority: 01.12.1997 US 982199; 01.12.1997 US 980686; 02.06.1998 US 88561; 17.07.1998 US 118626
(43) Date of publication of application: 07.07.1999
(73) Proprietor: Nichigo-Morton Co Ltd, Chuo-ku, Tokyo 104 (JP)
(72) Inventor: Barr, Robert, Laguna Niguel, California 92677 (US); Lundy, Daniel E., Placentia, California 92871 (US); Kosaka, Eiji, Ogaki, Gifu Prefecture 503-0805 (JP); Murakami, Shigeru, Ogaki, Gifu Prefecture 503-0917 (JP)
(74) Representative: Buckley, Guy Julian

(56) References cited:
- EP-A- 0 262 720
- EP-A- 0 531 019
- EP-A- 0 738 927
- FR-A- 2 104 217
- US-A- 5 328 803
- PATENT ABSTRACTS OF JAPAN vol. 6, no. 197 (C-128), 6 October 1982 (1982-10-06) & JP 57 108122 A (DAINIPPON INK & CHEM. INC.), 6 July 1982 (1982-07-06)

## Description

The present invention is directed to a negative-acting photoimageable composition useful as a photoresist for manufacturing printed circuit boards.

### Background of the Invention

This invention is directed to a negative-acting photoimageable composition which is developable in alkaline aqueous solutions. A variety of such photoimageable compositions are described. Essential components of compositions of the type to which the present invention is directed are A) a binder polymer; B) photopolymerizable α,β-ethylenically unsaturated compound(s), and C) a photoinitiator chemical system. The binder polymer A) has sufficient acid functionality, generally carboxylic acid functionality, that it is soluble in alkaline aqueous solution and thereby renders the photoimageable composition developable in alkaline aqueous solutions.

The present invention is directed to a photoimageable composition having improved adhesion and resolution, broad processing latitude, e.g., processed over a broad exposure range, a broad developing range, and good yield.

### Summary of the Invention

The negative-acting photoimageable composition comprises A) between about 30 and about 70 wt%, based on total weight of A) plus B), of a organic binder polymers having sufficient acid functionality to render the photoimageable composition developable in alkaline aqueous solution. The binder polymers A) comprise between about 3 and about 65 wt% relative to total of A) plus B) a binder polymer A') having a weight average molecular weight between about 5000 and about 40,000 and a T_{g} of between about 40 and about 100°C, and between about 5 and about 67 wt% relative to total of A) plus B) of a binder polymer A") having a weight average molecular weight between about 41,000 and about 200,000 and a T_{g} of between about 40 and about 100°C. The photoimageable composition further comprises B) between about 30 and about 60 wt%, based on total weight of A) plus B), of α,β-ethylenically unsaturated compounds. Component B) comprises B') an isocyanate trimer having tri-α,β-ethylenically unsaturated functionality, trimer B') being present at between about 2 to about 30 wt% based on total weight of A) plus B), and B") 0 to about 5 wt% based on total weight of A) plus B) of other α,β-ethylenically unsaturated compounds, at least about 50 mole percent of the α,β-ethylenically unsaturated functionality of B' and B" being methacrylate functionality. The composition further comprises C) between about 0.5 and about 15 wt%, based on total weight of A) plus B) of an organic, radiation-sensitive free-radical generating system, the photoinitiator chemical system C) comprising between about .005 and about 3 wt% relative to total weight of A) plus B) of triphenyphosphine and between about .005 and about 2 wt% relative to total weight of A) plus B) of n-phenylglycine.

### Detailed Description of Certain Preferred Embodiments

Herein, unless otherwise noted, all percentages are weight percentages. Component A) (the binder polymers) and Component B) (the photoimageable compounds) are herein considered to equal 100 wt%, and other components, such as the photoinitiator chemical system C), plasticizer, etc. are calculated as parts relative to 100 parts of A) plus B). Molecular weights of polymers and oligomers, unless otherwise stated, are weight average molecular weights.

The invention is directed to photoimageable compositions which are developable in alkaline aqueous solution and which therefore have binder polymer(s) with substantial acid functionality. Herein, the binder polymer component A) comprises a low molecular weight polymer A') and a high molecular weight binder A"), each having substantial acid functionality and each having a glass transition temperature (T_{g}) in the range of 40 to 100°C. The acid numbers of each polymer is at least about 80, preferably at least about 100 and more preferably about 150 or more, up to about 250. The acid functionality is typically carboxylic acid functionality, but may also include, for example, sulfonic acid functionality or phosphoric acid functionality.

The binder polymers A') and A") are each derived from a mixture of acid functional monomers and non-acid functional monomers. Some specific examples of suitable acid functional monomers are acrylic acid, methacrylic acid, maleic acid, fumaric acid, citraconic acid, 2-acrylamido-2-methylpropanesulfonic acid, 2-hydroxyethyl acrylolyl phosphate, 2-hydroxypropyl acrylol phosphate, 2-hydroxy-alpha-acryloyl phosphate, etc. One or more of such acid functional monomers may be used to form the binder polymer.

The acid functional monomers may be copolymerized with non-acid functional monomers, such as esters of acrylic acids, for example, methyl acrylate, methyl methacrylate, hydroxy ethyl acrylate, butyl methacrylate, octyl acrylate, 2-ethoxy ethyl methacrylate, t-butyl acrylate, n-butyl acrylate, 2-ethyl hexyl acrylate, n-hexyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

Examples of such polymers and photoimageable compositions using such polymers are found, in the following U.S. Patent Nos: 3,953,309, 4,003,877, 4,610,951, and 4,695,527 the teaching of each of which are incorporated herein by reference.

Binder polymer A') of the photoimageable compositions of the present invention has a weight average molecular weight between about 5000 and about 40,000 preferably between about 10,000 and about 30,000. These molecular weights are relatively low for this type of binder polymer; however, the improved adhesion and processing time of the photoimageable composition of the present invention is largely attributable to the utilization of low molecular weight binder polymer. Binder polymer A') is used in admixture with a higher molecular weight binder polymer A"), i.e., a weight average molecular weight between about 41,000 and about 200,000, preferably between about 60,000 and about 120,000 which has a relatively low T_{g,}, i.e., between about 40 and about 100. Higher molecular weight binder polymer A") is used to enhance tenting strength.

The photoimageable, acrylate functional, isocyanate trimer B') which comprises a portion of, and in some cases all of, the photopolymerizable component B) preferably has the general formula: 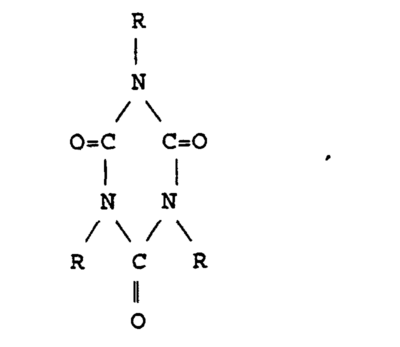 where R is -(CH₂)ₚ-NH-COO-(CHY-CHY-O)ₘ-CO-CX=CH₂, where X is H or CH₃, Y is H, CH₃, or C₂H₅, p is an integer from 1 to 36 and m is an integer from 1 to 14. Such trimers are described in European Patent Application EP 0 738 927 A2.

While the use of low molecular weight binder polymer enhances adhesion and processing time, the short chain polymers tend to reduce overall flexibility of the photoimageable composition. Poor flexibility can cause tented holes to fail and lines to fracture during the many mechanical handling steps, defects which necessitate scrapping printed circuit boards having such defects. The flexibility problem is addressed herein by the use, in conjunction with low molecular weight binder polymers, of the acrylate-functional isocyanate trimer B') (also referred to herein as the "urethane oligomer"). To this end, the molecular weight of the isocyanate trimer should be at least about 1000 and may be as high as about 5000. The relatively high molecular weight of the urethane oligomer B') compensates for the lower molecular weight of the binder polymer, producing a photoimageable composition with flexibility comparable to those formulations using higher molecular weight polymers.

The balance of photopolymerizable component B), used at 0 to about 5 wt% of the photoimageable composition (calculated relative to total weight of A) plus B) is B"), typically a monomer, dimer or short chain oligomer having ethylenic unsaturation, particularly α,β-ethylenic unsaturation, including monofunctional compounds and compounds having α,β-ethylenic unsaturation. Typically, a mixture of mono-functional and multi-functional monomers will be used. Suitable photopolymerizable compounds include, but are not limited to, the monomers recited above as suitable for forming binder polymers, particularly the non-acid functional compounds.

To initiate polymerization of the monomers upon exposure to actinic radiation, the photoimageable composition contains photoinitiator chemical system. At least a part of the photoinitiator chemical system of the present invention compurise a mixture of triphenylphosphine (TPPN) and n-phenylglycine (NPG). This combination is found to produce excellent photospeed without negative impact on adhesion, tenting strength or stability. NPG is used at between about 0.005 and about 3 wt% relative to total of A) plus B) and TPPN is used at between about 0.005 and about 2 wt % relative to total of A) plus B).

In addition to TPPN and NPG, other photoinitiator chemicals may be and typically are included as part of the photoinitiator chemical system. Generally, the photoinitiator chemical system in total comprises between about 0.1 and about 15 wt% based on total weight of A) plus B). Other photoinitiator chemicals include, but are not limited to 9-phenylacridine, aromatic ketones (benzophenone, N, N' -tetramethyl-4,4'-diaminobenzophenone [Michler's ketone], N,N'-tetraethyl-4,4'-diaminobenzophenone,4-methoxy-4'-dimethylaminobenzophenone, 3,3'-dimethyl-4-methoxybenzophenone, p,p'-bis(dimethylamino)benzophenone, p,p'-bis(diethylamino)-benzophenone, anthraquinone, 2-ethylanthraquinone, naphthaquinone, phenanthraquinone, benzoins (benzoin, benzoinmethylether, benzoinethylether, benzoinisopropylether, benzoin-n-butylether, benzoin-phenylether, methylbenzoin, ethybenzoin, etc.), benzyl derivatives (dibenzyl, benzyldiphenyldisulfide, benzyldimethylketal (SIC), etc.), acridine derivatives (9-phenylacridine, 1,7-bis(9-acridinyl)heptane, etc.), thioxanthones (2-chlorothioxanthone, 2-methylthioxanthone, 2,4-diethylthioxanthone, 2,4-dimethylthioxanthone, 2-isopropylthioxanthone, etc.), acetophenones (1,1-dichloroacetophenone, p-t-butyldichloroacetophenone, 2,2-diethoxyacetophenone, 2,2-dimethoxy-2-phenylacetophenone, 2,2-dichloro-4-phenoxyacetophenone, etc.), etc.. A preferred photoinitiator in addition to TPPN and NPG is 9-phenyl acridine, used at between about 0.05 and about 0.5 wt% relative to total of A) plus B). Also, suitable 9-phenyl acridine homologues, such as those described in U.S. Patent No. 5,217,845, the teachings of which are incorporated herein by reference, are useful photoinitiators.

It is preferred that the photoinitiator chemical system of the present invention include a lophine dimer (imidazole dimer) at between about 0.5 and about 10 wt% based on total weight of A) plus B). Examples of such lophine dimers include, but are not limited to triphenylbiimidazoles, especially 2,4,5-triphenylimidazole dimers such as 2,2'-bis(o-chlorophenyl)-4,4',5,5'-tetraphenylbiimidazole, 2,2'-bis(o-chlorophenyl)-4,4',5,5'-tetrakis(m-methoxyphenyl) biimidazole, 2,2'-bis(p-carboxyphenyl)-4,4',5,5'-tetraphenylbiimidazole, 2,2'-bis(p-chlorophenyl)-4,4',5,5'-tetrakis(p-methoxyphenyl)biimidazole, 2,2'-di-o-tolyl-4,4',5,5'-tetraphenylbiimidazole, 2,2'-di-p-tolyl-4,4'-di-o-tolyl-5,5'-diphenylbiimidazole, etc..; these can be used individually or two or more can be used in combination.

In conjunction with the lophine dimer, it is preferred that the composition contain a Leuco dye at between about 0.05 and about 2 wt% relative to A) plus B). The lophine dimer and Leuco dye contribute to through-cure of the exposed photoimageable composition. Suitable Leuco dyes include bis-chlorimidazole, leuco malachite green, leuco aniline, leuco methyl violet, etc.

As a preferred aspect of the invention, flexibility, is further improved through the use of plasticizers. A preferred plasticizer is para-toluene sulfonamide.

Also useful are dibenzoate plasticizers. Useful dibenzoate plasticizers have the general formula:

C₆H₅-COO-[R]ₙ-R'-C₆H₅ ,

where

R = -CHX-CHX-O-

where one or both Xs are H or one X may be CH₃ and the other H; n = 1 to 10, and

R' is -CH₂-CH(CH₃)-OOC-, -CH₂-CH₂-OOC-, or -OC-.

Specific examples of suitable dibenzoates include, but are not limited to dipropyleneglycol dibenzoate, diethylene glycol dibenzoate, polypropyleneglycol dibenzoate, and polyethylene glycol dibenzoate.

Plasticizer D), if used, is used at levels of between about 1 and about 10 wt% relative to total weight of A) plus B), typically at between about 2 and about 6 wt%.

Processing of the photoimageable composition is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

The invention will now be described in greater detail by way of specific example.

### Example

A photoimageable is prepared having the following components:

| Component | Wt% | Function |
|---|---|---|
| Binder A' | 12.49 | Low Molecular weight Binder* |
| Binder A" ' | 38.89 | Low T_{g} binder** |
| Urethane acrylate | 15.37 | Photopolymerizable oligomer |
| Bis A ethoxylate dimethacrylate | 13.67 | Photopolymerizable oligomer |
| Propylene oxide, mono methacrylate | 10.80 | Photopolymerizable monomer |
| Michler's ethyl ketone | 0.05 | UV absorber |
| Lophine dimer (bis-chlorimidazole) | 3.50 | Color activator/photoinitiator |
| Leuco crystal violet | 0.40 | Color formor |
| Malichite green | 0.05 | Dye |
| Paratoluene sulfonamide | 4.48 | Plasticizer |
| 9-phenyl acridine | 0.12 | Photoinitiator |
| Triphenylphosphine | 0.05 | Photo accelerator |
| n-phenyl glycine | 0.03 | Photoinitiator |
| o-phthalic acid | 0.06 | Anti-oxidizer |
| Modaflow® | 0.10 | Flow control agent |

| | | |
|---|---|---|
| * Mw= 20,000; T_{g} = 95; Acid No. = 239. | | |
| **Mw= 80,000; T_{g} = 90; Acid No. = 149. | | |

The composition was prepared in 7:1 2-Butanone:2-Propanol at approximately 50% solids. The solutions was coated onto biaxially oriented 80 gauge polyester film and dried to approximately 1% or less retained solvent. The coated mixture was then laminated onto mechanically scrubbed 1 oz./FR-4/1 oz. clad copper composite using a hot roll laminator at 110°C at 2 meters/minute and 3 bar pressure.

The laminated material was then imaged on a UV printer through an appropriate phototool with an adjusted exposure to obtain a copper step of 7 as measured with a Stouffer® 21 step wedge (approximately 20 mJ/cm²). The exposed panels were then developed in a 1 % sodium carbonate monohydrate solution at 29°C using a conveyorized spray developer at about 26 psi with residence time adjusted so that the break point occurred at 40% to 50% of the chamber length (unless otherwise noted in the specific example), followed by several spray rinses using tap water and the deionized water.

Etching was accomplished using a 2N cupric chloride/hydrochloric acid solution at 48°C in a conveyorized etcher equipped with multiple spray nozzles. The etched board was then stripped of the imaged, developed and etched photo resist in a 3 % sodium hydroxide solution at 54°C in a conveyorized stripping unit equipped with mutiple spray nozzles followed by a spray rinse of tap water.

Process responses for the examples are cited at various points throughout the above procedure. Results are shown below:

| Thickness | 38µm |
|---|---|
| Photospeed | |
| ST-6 | 27 mJ |
| ST-7 | 40 mJ |
| ST-8 | 55 mJ |
| ST-9 | 68 mJ |
| Resist Stripping | 34-39 sec. |
| (3% NaOH 50°C, 1.5 Kg/cm²) | |
| | |
| Resolution (with equal line and space at 2x breakpoint) | 30µm |
| | |
| Adhesion (with 400 µm space at 2x breakpoint) | 25µm |
| | |
| Tent Strength at 20°C | 4.5mm |
| | 415 g. |

## Claims

1. A photoimageable composition comprising:
(A) between 30 and 70 wt.% of organic binder polymers having sufficient acid functionality to render said photoimageable composition developable in alkaline aqueous solution, said binder polymers comprising:
A') between 3 and 65 wt.% of a binder polymer having a weight average molecular weight between 5000 and 40,000 and a T_{g} of between 40 and 100°C, and
A") between 5 to 67 wt.% of a binder polymer having a weight average molecular weight between 41,000 and 200,000 and a T_{g} of between 40 and 100°C,
(B) between 30 and 60 wt.%, based on total weight of
(A) plus (B), of α,β-ethylenically unsaturated compounds, said component (B) comprising:
B') 20 to 30 wt.% of an isocyanate trimer having tri-α,β-ethylenically unsaturated functionality, said trimer being present in an amount of 2 to 30 wt.%, and
B") 0 to 5 wt.% of other α, β-ethylenically unsaturated compounds, at least 50 mole percent of the α, β-ethylenically unsaturated functionality of (B') and (B") being methacrylate functionality, and
(C) between 0.5 and 15 wt.% of an organic, radiation-sensitive free-radical generating photoinitiator chemical system, comprising between 0.005 and 3 wt.% of triphenylphosphine and between 0.005 and 2 wt.% of n-phenylglycine,
all said percentages being based on the total weight of (A) plus (B).

2. A photoimageable composition according to claim 1 further comprising:
(D) 1 to 10 wt.%, relative to weight of (A) plus (B), of plasticizer.

3. A photoimageable composition according to claim 2 wherein said plasticizer (D) comprises paratoluenesulfonamide.

4. A photoimageable composition according to any preceding claim wherein said free-radical generating system (C) further comprises 9-phenyl acridine at between 0.05 and 0.5 wt.% relative to weight of (A) plus (B).

5. A photoimageable composition according to any preceding claim further comprising:
(E) from 0.5 to 10 wt.% of a lophine dimer and from 0.5 to 2.0 wt.% of a Leuco dye, both percentages being based on total weight of (A) plus (B).

6. A photoimageable composition according to any preceding claim wherein said binder polymer (A') has a weight average molecular weight between 10,000 and 30,000.

7. A photoimageable composition according to any preceding claim wherein said binder polymer (A") has a weight average molecular weight between 60,000 and 120,000.

8. A photoimageable composition according to any preceding claim wherein each binder polymer (A) has an acid number of at least 80.

9. A photoimageable composition according to claim 8 wherein each binder polymer (A) has an acid number of 100 to 250.

10. A photoimageable composition according to any preceding claim wherein the acrylate functional isocyanate trimer (B') has the general formula 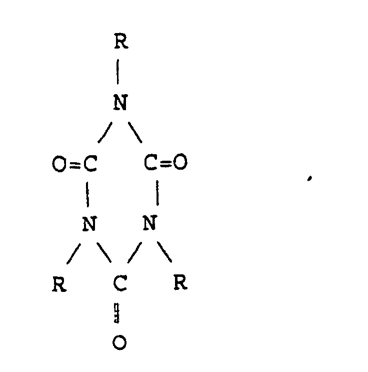 where R is -(CH₂)ₚ-NH-COO-(CHY-CHY-O)ₘ-CO-CX=CH₂, where X is H or CH₃, Y is H, CH₃, or C₂H₅, p is an integer from 1 to 36 and m is an integer from 1 to 14.

## Patentansprüche

1. Photo-darstellbare Zusammensetzung, welche umfasst:
(A) zwischen 30 und 70 Gew.-% von organischen Bindemittelpolymeren mit ausreichender Säurefunktionalität, um die Photo-darstellbare Zusammensetzung in alkalischer wässriger Lösung entwickelbar zu machen, wobei die Bindemittelpolymere umfassen:
A') zwischen 3 und 65 Gew.-% eines Bindemittelpolymers mit einem massegemittelten Molekulargewicht zwischen 5000 und 40.000 und einer T_{g} von zwischen 40 und 100°C, und
A") zwischen 5 bis 67 Gew.-% eines Bindemittelpolymers mit einem massegemittelten Molekulargewicht zwischen 41.000 und 200.000 und einer T_{g} von zwischen 40 und 100°C,
(B) zwischen 30 und 60 Gew.-%, bezogen auf das Gesamtgewicht von (A) plus (B), von α,β-ethylenisch ungesättigten Verbindungen, wobei Verbindung (B) umfasst:
B') 20 bis 30 Gew.-% eines Isocyanattrimers mit tri-α,β-ethylenisch ungesättigter Funktionalität, wobei das Trimer in einer Menge von 2 bis 30 Gew.-% vorliegt, und
B") 0 bis 5 Gew.-% von anderen α,β-ethylenisch ungesättigten Verbindungen, wobei mindestens 50 Mol-% der α,β-ethylenisch ungesättigten Funktionalität von (B') und (B") Methacrylat-Funktionalität besitzen, und
(C) zwischen 0,5 und 15 Gew.-% eines organischen, bestrahlungsempfindlichen Radikal-erzeugenden photochemischen Initiatorsystems, umfassend zwischen 0,005 und 3 Gew.-% Triphenylphosphin und zwischen 0,005 und 2 Gew.-% n-Phenylglycin,
wobei sich alle Prozentangaben auf das Gesamtgewicht von (A) plus (B) beziehen.

2. Photo-darstellbare Zusammensetzung gemäß Anspruch 1, welche weiter umfasst:
(D) 1 bis 10 Gew.-% Weichmacher, bezogen auf das Gewicht von (A) plus (B).

3. Photo-darstellbare Zusammensetzung gemäß Anspruch 2, worin der Weichmacher (D) Paratoluolsulfonamid umfasst.

4. Photo-darstellbare Zusammensetzung gemäß einem der vorangehenden Ansprüche, worin das Radikal-erzeugende System (C) weiter zwischen 0,05 und 0,5 Gew.-% 9-Phenylacridin, bezogen auf das Gewicht von (A) plus (B), umfasst.

5. Photo-darstellbare Zusammensetzung gemäß einem der vorangehenden Ansprüche, welche weiter umfasst:
(E) von 0,5 bis 10 Gew.-% eines Lophindimers und von 0,5 bis 2,0 Gew.-% eines Leuco-Farbstoffes, wobei sich beide Prozentangaben auf das Gesamtgewicht von (A) plus (B) beziehen.

6. Photo-darstellbare Zusammensetzung gemäß einem der vorangehenden Ansprüche, worin das Bindemittelpolymer (A') ein massegemitteltes Molekulargewicht zwischen 10.000 und 30.000 aufweist.

7. Photo-darstellbare Zusammensetzung gemäß einem der vorangehenden Ansprüche, worin das Bindemittelpolymer (A") ein massegemitteltes Molekulargewicht zwischen 60.000 und 120.000 aufweist.

8. Photo-darstellbare Zusammensetzung gemäß einem der vorangehenden Ansprüche, worin jedes Bindemittelpolymer (A) eine Säurezahl von mindestens 80 aufweist.

9. Photo-darstellbare Zusammensetzung gemäß Anspruch 8, worin jedes Bindemittelpolymer (A) eine Säurezahl von 100 bis 250 aufweist.

10. Photo-darstellbare Zusammensetzung gemäß einem der vorangehenden Ansprüche, worin das Acrylat-funktionelle Isocyanattrimer (B') folgende allgemeine Formel aufweist 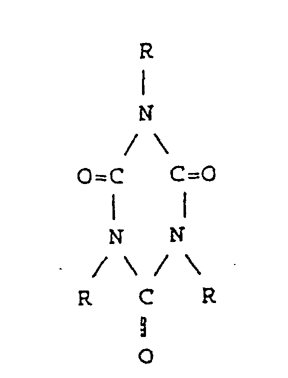 worin R für -(CH₂)ₚ-NH-COO-(CHY-CHY-O)ₘ-CO-CX=CH₂ steht, worin X für H oder CH₃ steht, Y für H, CH₃ oder C₂H₅ steht, p eine ganze Zahl von 1 bis 36 und m eine ganze Zahl von 1 bis 14 ist.

## Revendications

1. Composition photoimageable, comprenant :
(A) de 30 à 70 % en poids de polymères liants organiques ayant une fonctionnalité acide suffisante pour rendre ladite composition photoimageable développable dans une solution alcaline aqueuse, lesdits polymères liants comprenant :
A') de 3 à 65 % en poids d'un polymère liant ayant une masse moléculaire moyenne en poids comprise entre 5000 et 40 000 et une T_{g} comprise entre 40 et 100°C, et
A") de 5 à 67 % en poids d'un polymère liant ayant une masse moléculaire moyenne en poids comprise entre 41 000 et 200 000 et une T_{g} comprise entre 40 et 100°C,
(B) de 30 à 60 % en poids, par rapport au poids total de (A) et de (B), de composés à insaturation α,β-éthylénique, ledit composant (B) comprenant :
B') de 20 à 30 % en poids d'un trimère d'isocyanate ayant une fonctionnalité d'insaturation tri-α,β-éthylénique, ledit trimère étant présent en une quantité de 2 à 30 % en poids, et
B") de 0 à 5 % en poids d'autre composés à insaturation α,β-éthylénique, au moins 50 % en mole de la fonctionnalité d'insaturation α,β-éthylénique de (B') et de (B") étant une fonctionnalité méthacrylate, et
(C) de 0,5 à 15 % en poids d'un système chimique photoamorceur organique, formant des radicaux libres et sensible au rayonnement, comprenant de 0,005 à 3 % en poids de triphénylphosphine et de 0,005 à 2 % en poids de n-phénylglycine,
tous lesdits pourcentages étant rapportés au poids total de (A) et de (B).

2. Composition photoimageable selon la revendication 1, comprenant en outre :
(D) de 1 à 10 % en poids, par rapport au poids de (A) et de (B), d'un plastifiant.

3. Composition photoimageable selon la revendication 2, dans laquelle ledit plastifiant (D) comprend du paratoluènesulfonamide.

4. Composition photoimageable selon l'une quelconque des revendications précédentes, dans laquelle ledit système produisant des radicaux libres (C) comprend en outre de la 9-phénylacridine en une quantité de 0,05 à 0,5 % en poids par rapport au poids de (A) et de (B).

5. Composition photoimageable selon l'une quelconque des revendications précédentes, comprenant en outre :
(E) de 0,5 à 10 % en poids d'un dimère de lophine et de 0,5 à 2,0 % en poids d'un leucodérivé de colorant, les deux pourcentages étant rapportés au poids total de (A) et de (B).

6. Composition photoimageable selon l'une quelconque des revendications précédentes, dans laquelle ledit polymère liant (A') a une masse moléculaire moyenne en poids comprise entre 10 000 et 30 000.

7. Composition photoimageable selon l'une quelconque des revendications précédentes, dans laquelle ledit polymère liant (A") a une masse moléculaire moyenne en poids comprise entre 60 000 et 120 000.

8. Composition photoimageable selon l'une quelconque des revendications précédentes, dans laquelle chaque polymère liant (A) a un indice d'acide d'au moins 80.

9. Composition photoimageable selon la revendication 8, dans laquelle chaque polymère liant (A) a un indice d'acide de 100 à 250.

10. Composition photoimageable selon l'une quelconque des revendications précédentes, dans laquelle le trimère d'isocyanate à fonctionnalité acrylate (B') a la formule générale 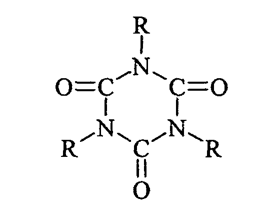 dans laquelle R est -(CH₂)ₚ-NH-COO-(CHY-CHY-O)ₘ-CO-CX=CH₂, où X est H ou CH₃, Y est H, CH₃ ou C₂H₅, p est un entier de 1 à 36, et m est un entier de 1 à 14.
